# EUROPEAN PATENT APPLICATION

(11) **EP 2 312 918 A1**
(43) Date of publication of application: **20.04.2011**
(21) Application number: 10186675.4
(22) Date of filing: 06.10.2010
(51) Int. Cl.: H05K 1/02, H01L 33/64, F21K 99/00, F21Y 101/02

(54) **Illumination Device**

(30) Priority: 16.10.2009 CN 200910308355
(71) Applicant: Foxsemicon Integrated Technology, Inc., Miao-Li, Hsien 350 (TW)
(72) Inventor: Chen, Ping-Yu, 350, Miao-Li Hsien (TW); Chiang, Kuo-Feng, 350, Miao-Li Hsien (TW); Lu, Chien-Ting, 350, Miao-Li Hsien (TW); Huang, Zheng-Jay, 350, Miao-Li Hsien (TW); Lu, Ying-Chieh, 350, Miao-Li Hsien (TW)
(74) Representative: Wilson, Peter

(57) **Abstract**

An illumination device (100) includes a heat sink (10), at least one solid-state lighting source (20) and a printed circuit board (30). The heat sink (10) includes a support portion (11). The solid-state lighting source (20) includes a light-emitting surface (22) and a bottom surface (24) opposite to the light-emitting surface (22). The bottom surface is mounted on the support portion of the heat sink. The printed circuit board includes a circuit and at least one through hole (32) for receiving the solid-state lighting source. The circuit of the printed circuit board is electrically connected with an electrode of the solid-state lighting source.

## Description

### BACKGROUND

### 1. Technical Field

The present disclosure relates to illumination devices, and more particularly to an illumination device having high efficiency of heat dissipation.

### 2. Description of Related Art

A LED lamp includes a heat sink, a printed circuit board and a plurality of LEDs. The printed circuit board is mounted on a central portion of the heat sink. The LEDs are mounted on the printed circuit board. Because of the heat transfer coefficient of the printed circuit board is poor it is difficult for the heat sink to dissipate the heat from the LEDs.

It is thus desirable to provide an illumination device which can overcome the described limitations.

### BRIEF DESCRIPTION OF THE DRAWINGS

Many aspects of the present disclosure can be better understood with reference to the following drawings. The components in the drawings are not necessarily drawn to scale, the emphasis instead being placed upon clearly illustrating the principles of the present disclosure. Moreover, in the drawings, like reference numerals designate corresponding parts throughout the several views.

FIG. 1 is a schematic view of an illumination device in accordance with a first embodiment.

FIG. 2 is a schematic view of an illumination device in accordance with a second embodiment.

FIG. 3 is a schematic view of an illumination device in accordance with a third embodiment.

### DETAILED DESCRIPTION

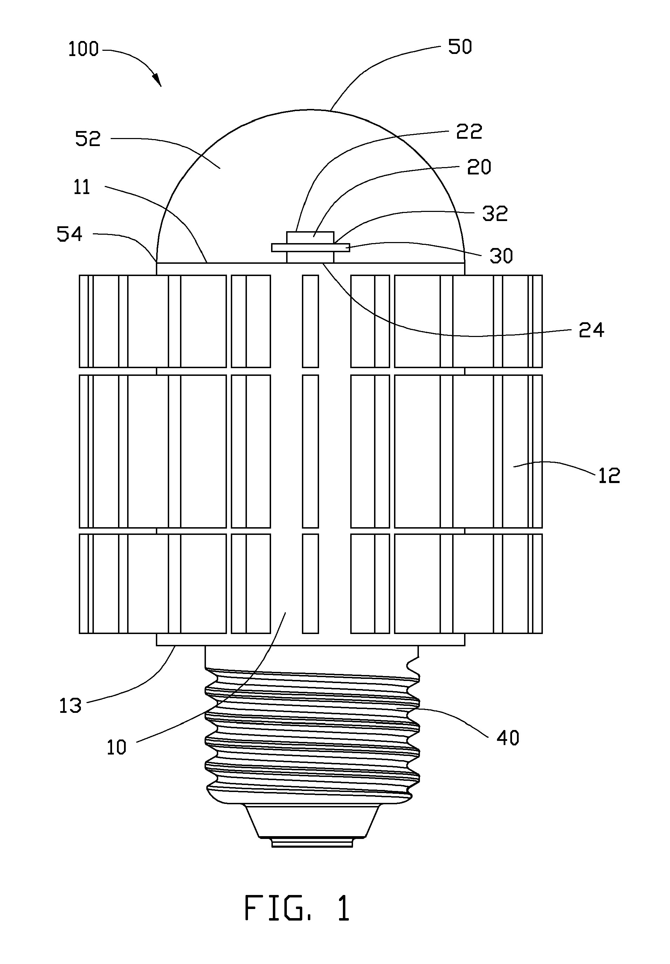

Referring to FIG. 1, an illumination device 100 according to first embodiment includes a heat sink 10, at least one solid-state lighting source 20, a printed circuit board 30, a connecting member 40 for electrically connecting a power source (not shown), and a transparent or translucent envelope 50 which is made of glass or plastic.

The heat sink 10 includes a support portion 11, a connecting portion 13 and a plurality of fins 12. The fins 12 radially align about an outer circumferential surface of the heat sink 10 to dissipate the heat of the heat sink 10. The support portion 11 of the heat sink 10 is a flat surface to support the solid-state lighting source 20 thereon. The heat sink 10 is made of aluminum or copper.

The solid-state lighting source 20 includes a light-emitting surface 22 and a bottom surface 24 opposite to the light-emitting surface 22. The bottom surface 24 of the solid-state lighting source 20 is mounted on the support portion 11 of the heat sink 10. In this embodiment, the solid-state lighting source 20 is a LED. A thermally conductive adhesive is interposed between the bottom surface 24 of the solid-state lighting source 20 and the support portion 11 of the heat sink 10, whereby the solid-state lighting source 20 is securely and directly mounted on the support portion 11 and thermally connects therewith, without through a printed circuit board.

At least one through hole 32 is defined in the printed circuit board 30 for receiving the solid-state lighting source 20. An electrode of the solid-state lighting source 20 is electrically connected with a circuit on the printed circuit board 30. In this embodiment, the printed circuit board 30 is a flexible printed circuit board. There is a gap in between the printed circuit board 30 and the support portion 11 of the heat sink 10.

The connecting member 40 is mounted on the connecting portion 13 of the heat sink 10. The connecting member 40 is electrically connected with the printed circuit board 30 by a wire (not shown). The connecting member 40 is a standard element with a thread formed thereon, so the illumination device 100 can be directly connected to a standard socket matching with the standard connecting member 40 to electrically connect with the power source. The illumination device 100 thus can replace an incandescent bulb or a compact bulb having a connector with a similar configuration as that of the connector 40.

The envelope 50 includes a receiving space 52 and an opened end 54. The opened end 54 of the envelope 50 is mounted on the support portion 11 of the heat sink 10 and covers the solid-state lighting source 20. The envelope 50 has a hollow, substantially hemisphere-shaped configuration is made of a light permeable material. The envelope 50 is an optical element, which can be used to adjust illuminating pattern of the light from the solid-state lighting source 20.

The bottom surface 24 of the solid-state lighting source 20 is directly connected with the support portion 11 of the heat sink 10. The solid-state lighting source 20 easily dissipates heat to the heat sink 10. Thus, high efficiency of heat dissipation is available and the lifespan of the illumination device 100 is increased in daily use.

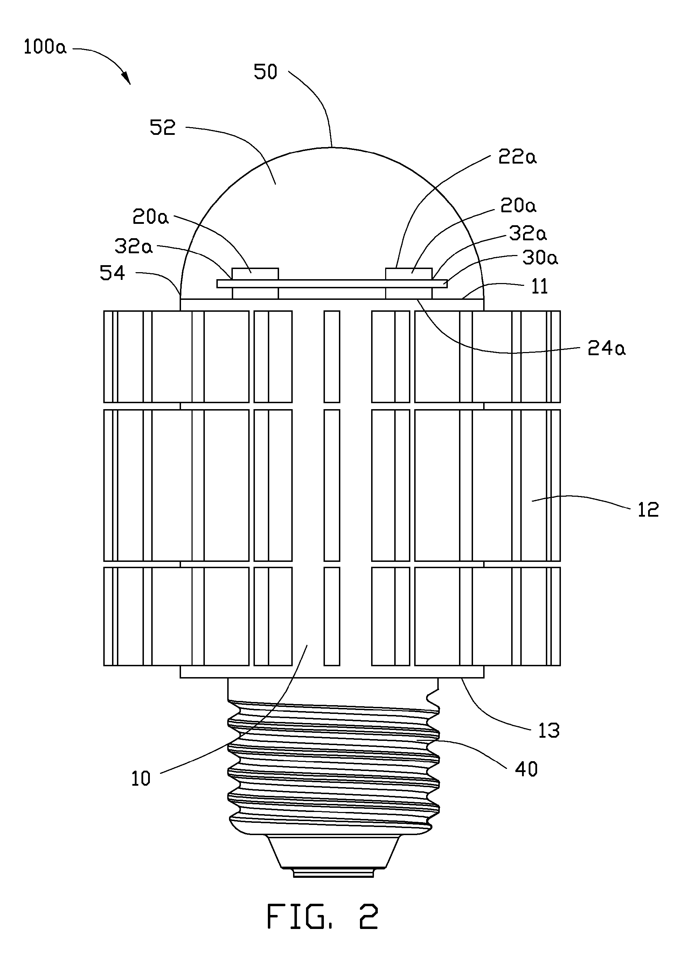

FIG. 2 illustrates an illumination device 100a of a second embodiment of the disclosure, differing from the first embodiment only in that a plurality of through holes 32a is defined in the printed circuit board 30a. A plurality of solid-state lighting sources 20a is received in the through holes 32a of the printed circuit board 30a. Each bottom surface 24a of the solid-state lighting sources 20a is directly connected with the support portion 11 of the heat sink 10. The printed circuit board 30a defines two through holes 32a through which the solid-state lighting sources 20a extend. Each electrode of the solid-state lighting sources 20a is electrically connected with a circuit on the printed circuit board 30a. Each solid-state lighting source 20a has a light-emitting surface 22a facing upwardly toward the envelope 50. Furthermore, each solid-state lighting source 20a has a bottom surface 24a directly secured to the support portion 11 and thermally connecting therewith.

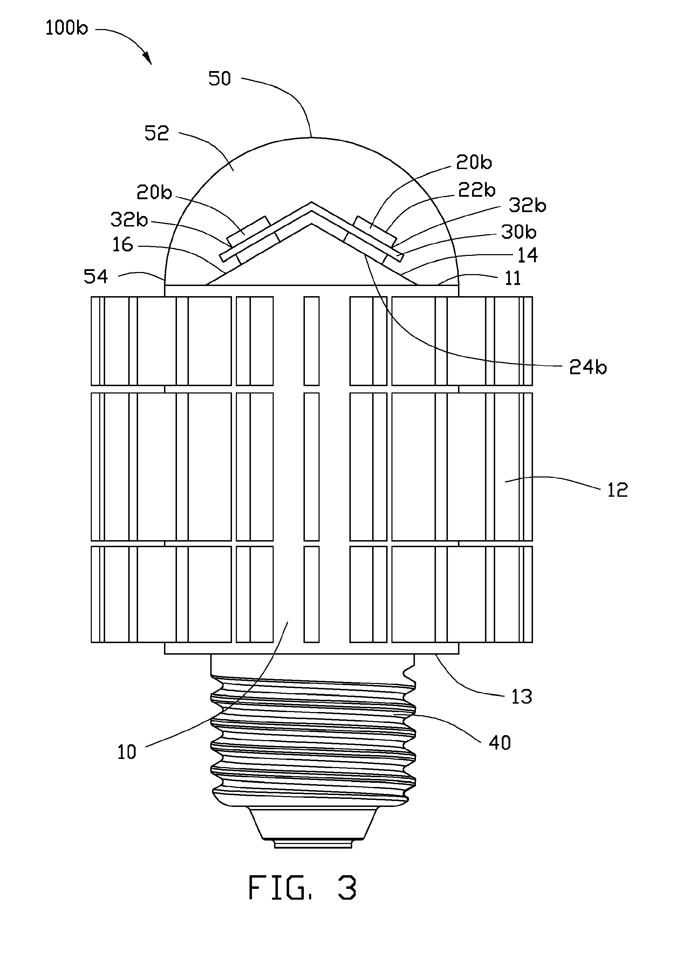

FIG. 3 illustrates an illumination device 100b of a third embodiment of the disclosure, differing from the second embodiment only in that the support portion 11 includes two inclined planes 14 and 16. Each bottom surface 24b of the solid-state lighting sources 20b is directly connected with a corresponding one of the inclined planes 14 and 16 of the heat sink 10. Each electrode of the solid-state lighting sources 20b is electrically connected with a circuit on the printed circuit board 30b. The printed circuit board 30b defines two through holes 32b through which the solid-state lighting sources 20b extend. The shape of the printed circuit board 30b is corresponding to the inclined planes 14 and 16 of the heat sink 10. Each solid-state lighting source 20b has a light-emitting surface 22b facing upwardly and laterally toward the envelope 50. Furthermore, each solid-state lighting source 20b has a bottom surface 24b directly secured to the support portion 11 and thermally connecting therewith.

It is to be understood, however, that even though numerous characteristics and advantages of various embodiments have been set forth in the foregoing description, together with details of the structures and functions of the embodiments, the disclosure is illustrative only; and that changes may be made in detail, especially in matters of arrangement of parts within the principles of the invention to the full extent indicated by the broad general meaning of the terms in which the appended claims are expressed.

## Claims

1. An illumination device comprising:
a heat sink comprising a support portion;
at least one solid-state lighting source comprising a light-emitting surface and a bottom surface opposite to the light-emitting surface, the bottom surface directly mounted on the support portion of the heat sink and thermally connecting therewith; and
a printed circuit board comprising at least one through hole for receiving the at least one solid-state lighting source, the printed circuit board electrically connected with the at least one solid-state lighting source.

2. The illumination device of claim 1, wherein the heat sink comprises a plurality of fins, the fins radially aligned about an outer circumferential surface of the heat sink to dissipate the heat of the heat sink.

3. The illumination device of claim 1 or claim 2, wherein the heat sink is made of aluminum or copper.

4. The illumination device of any preceding claim, wherein the support portion of the heat sink is a flat surface and the light-emitting surface of the at least one solid-state lighting source is a top surface thereof and faces upwardly away from the support portion.

5. The illumination device of any preceding claim, wherein the support portion comprises an inclined plane, the at least one solid-state lighting source is directly connected with the inclined plane of the heat sink, the light-emitting surface of the at least one solid-state lighting source is a top surface thereof and faces upwardly and laterally away from the support portion.

6. The illumination device of any preceding claim, wherein the printed circuit board is a flexible printed circuit board.

7. The illumination device of any preceding claim, further comprising a connecting member, the connecting member being mounted on a connecting portion of the heat sink, the connecting member being electrically connected with the printed circuit board.

8. The illumination device of any preceding claim, further comprising an envelope, the envelope comprising a receiving space and an opened end, the opened end of the envelope being mounted on the support portion of the heat sink and covering the at least one solid-state lighting source.

9. The illumination device of claim 8, wherein the envelope is made of a light permeable material, and the envelope is an optical element for adjusting illuminating pattern of the light from the at least one solid-state lighting source.

10. The illumination device of any preceding claim, further comprising a thermally conductive adhesive, the thermally conductive adhesive being interposed between the bottom surface of the at least one solid-state lighting source and the support portion of the heat sink.

11. The illumination device of any preceding claim, wherein a gap is between the printed circuit board and the support portion of the heat sink.

12. The illumination device of any preceding claim, wherein the at least one solid-state lighting source is a LED.
